Europäisches Patentamt

European Patent Office

Office européen des brevets

(11) Publication number: **0 225 681**
**A1**

## EUROPEAN PATENT APPLICATION

(21) Application number: 86305142.1

(22) Date of filing: 02.07.86

(51) Int. Cl.⁴: **G01R 19/165**

The title of the invention has been amended (Guidelines for Examination in the EPO, A-III, 7.3).

(30) Priority: 16.07.85 GB 8517868

(43) Date of publication of application:
**16.06.87 Bulletin 87/25**

(84) Designated Contracting States:
**DE FR GB SE**

(71) Applicant: **HOLSET ENGINEERING COMPANY LIMITED**
**P.O. Box A9**
**Turnbridge Huddersfield, HD1 6RD(GB)**

(72) Inventor: **Franklin, Philip C.**
**3 Marten Drive**
**Netherton Huddersfield(GB)**
Inventor: **Ogburn, Alan P.**
**39 Chesterton Lane**
**Cirencester Gloucestershire(GB)**

(74) Representative: **Mair, Richard Douglas et al**
**F.J. Cleveland & Company 40-43 Chancery Lane**
**London WC2A 1JQ(GB)**

(54) **Electrical detecting device.**

(57) A device for detecting whether the voltage at a point (A) is low, high or floating comprises a first voltage source (V1), a second voltage source (V2) having a voltage less than the voltage of the first source, and a series of diodes( D2a, D2b) for connection at one end to the point (A). The diodes exhibit a voltage drop when they conduct and it is this voltage drop which is used in the analysis of the voltage at the point (A). A first resistor -(R1) is connected between the said one end of the diodes (D2a, D2b) and the second voltage source (V2), and a second resistor (R2) is connected between the other end of the diodes (D2a, D2b) and the first voltage source -(V1). Means (R4, R5, R6, R7, T1, T2) responsive to the voltages on either side of the diodes (D2a, D2b) provides an indication of the voltage at the point.

FIG.1

## "Electrical Device"

This invention relates to electrical devices and in particular to a device for detecting whether the voltage at a point is low, high or floating.

In certain electrical situations it is required to know whether the voltage at a point is a high value, a low value or floating. The "floating" condition may typically indicate a fault in that the point has become isolated from any electrical source. As an example, an indication may be required as to whether an electrical component is energised, earthed or whether a fault condition exists.

The invention provides a device for detecting whether the voltage at a point is low, high or floating comprising

a first voltage source,

a second voltage source having a voltage less than the voltage of the first source,

voltage drop causing means for connection at one end to the point,

a first resistor connected between the said one end of the voltage drop causing means and the second voltage source,

a second resistor connected between the other end of the voltage drop causing means and the first voltage source, and

means responsive to the voltages on either side of the voltage drop causing means to provide an indication of the voltage at the point.

The voltages either side of the voltage drop causing means will depend on whether the voltage at the point is high, low or floating and this is used to provide the required indication.

The voltage drop causing means may for example comprise at least one diode, preferably two diodes in series, with its or their conducting direction away from the first source. An inherent characteristic of diodes is that they exhibit a voltage drop when conducting.

The one end of the voltage drop causing means may be connected to the point via a third resistor.

The resistance of the second resistor, in one arrangement, is not considerably less than the resistance of the third resistor. The resistances of the second and third resistors may advantageously be of approximately the same magnitude.

The resistance of the first resistor may be much greater, such as more than ten times greater, than the resistance of the second resistor and/or of the third resistor.

The device preferably further comprises a diode connected between the one end of the voltage drop causing means and the first voltage source with its conducting direction towards that source.

Optionally, a diode may be connected between the one end of the voltage drop causing means and the second source with its conducting direction away from that source.

The voltage responsive means preferably comprises first and second transistors each connected between the first and second sources and having their bases connected respectively to either side of the voltage drop causing means. In a preferred arrangement, the transistors are of pnp type with their emitters connected to the first source and their collectors connected to the second source. With the collectors connected via resistors to the second source, the voltages at the collectors may be used to provide the required indication of the voltage at the point.

An embodiment of the invention will now be described, by way of example, with reference to the accompanying drawings, in which:

Figure 1 is a circuit diagram of a device according to the invention; and

Figure 2 is a truth table showing the logic outputs at output points X and Y for certain inputs at the input point A of the circuit of Figure 1.

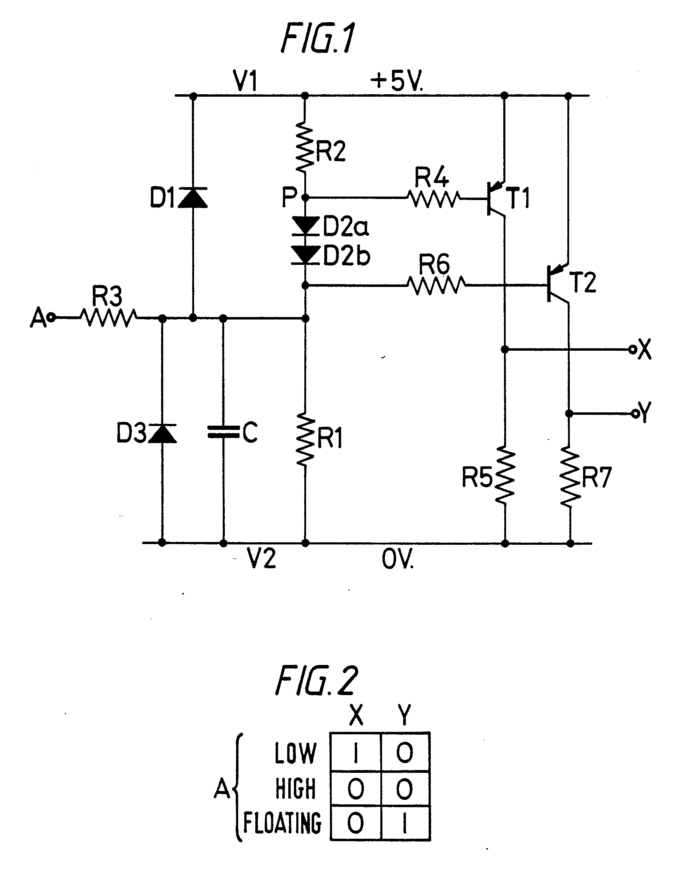

The circuit of Figure 1 is for detecting whether the voltage at point A is low, high or floating. The circuit has been devised for monitoring the state of a solenoid valve in the exhaust conduit of an internal combustion engine of a road vehicle , the valve acting to increase the pressure in the conduit between the engine and the valve whereby to effect retarding of the engine. One end of the solenoid is connected to earth and the other end is connectable by a switch to the vehicle power supply which is typically at 12 or 24 volts. Point A of the circuit of Figure 1 is connected to that other end of the solenoid. The circuit shown in Figure 1 is accordingly to detect whether the voltage at Point A is 0 V (when the solenoid is not energised, the switch being open), 12 volts (when the switch is closed and therefore the solenoid energised) or floating. The floating condition is a fault condition in which there is a break in the line somewhere between Point A and the earth connection of the solenoid. An alternative arrangement could be to have one end of the solenoid connected permanently to the live side of the vehicle battery, the switch being used to ground the other end of the solenoid.

Although the circuit has been devised in the above particular context, it is of course suitable for any application in which it is desired to detect whether the voltage at a point is low, high or floating.

A resistor R3, to limit the input current, is connected at one end to point A and its other end is connected via a first diode D1 to a first voltage source V1 having a voltage between the low and high voltages to be detected at A. In the embodiment, V1 is at +5 volts. The conducting direction of the first diode D1 is towards this voltage source; this diode protects against the situation when the voltage at point A is very much greater than the voltage of V1. Also connected to the other end of the resistor R3 are two second diodes D2a and D2b in series, with their conducting direction towards the resistor R3. The other side of the two second diodes is connected via a second resistor R2 to the first voltage source V1. A resistor R1 is connected between the other end of resistor R3 and a second voltage source V2 which is at a lower potential than the first source V1. In the embodiment, V2 is at ground potential, 0 V. The resistances R2 and R3 are of approximately the same magnitude but each is much smaller than the resistance of resistor R1.

To protect against reverse polarity arising between the second voltage source V2 and the other end of the resistor R3, a third diode D3 is connected in parallel with resistor R1 with its conducting direction away from the second voltage source V2. Reverse polarity might for example arise due to a fault in the second voltage source V2.

A capacitor C is optionally provided, also in parallel with resistor R1, to smooth out any AC component in the voltage at point A.

When a diode conducts, it exhibits a voltage drop which is quantifiable and it is the voltage drops across the first diode D1 and the second diodes D2a and D2b which are utilised to create different voltages at points P and Q on either side of the second diodes according to whether the voltage at point A is low, high or floating, as will be described in further detail hereinafter. The voltage drop across a diode, which is an inherent characteristic, varies slightly with temperature but is usually in the range of about 0.4 volts to 1.5 volts with standard components. A very typical average value is 0.7 volts.

One possible means of decoding the voltages at points P and Q, and converting them into a logic output, is shown in the right-hand portion of Figure 1. Two pnp type transistors T1 and T2 are connected between the two voltage sources, with their emitters connected directly to the first voltage source V1 and their collectors connected via resistors R5 and R7 respectively to the second voltage source V2. The transistors are made responsive to the voltages at points P and Q by virtue of their bases being respectively connected to those points through resistors R4 and R6. Output points X and Y are connected to the collectors of the transistors T1 and T2 respectively. The voltages at points X and Y relative to the second voltage source V2 at ground potential are used as logic outputs as will be described below.

An example of the values and types of the circuit components is as follows:

| | |
|---|---|
| R1 | 270K (ohms) |
| R2 | 24K |
| R3 | 18K |
| R4 | 1K |
| R5 | 22K |
| R6 | 47K |
| R7 | 22K |
| C | 0.047uF |
| D1, D2a, D2b, D3 | type 1N4148 |
| T1, T2 | type 2N3906 |

The voltages at points P and Q and the logic outputs at points X and Y will now be considered for the three cases of the voltage at point A being low (0 V), high (12 V) and floating, taking the voltage drop across each diode to be 0.7 V when it conducts.

Point A Low (0 V)

In this condition, diode D1 is reverse biased and therefore does not conduct. The second diodes D2a and D2b do however conduct, creating a combined voltage drop between points P and Q of about 1.4 volts. Because resistor R1 is very large, typically more than ten times larger than either resistor R2 or resistor R3, the electrical path through resistor R1 to ground can effectively be ignored. Considering therefore the path from source V1 through resistor R2, the second diodes and resistor R3 to point A at 0 V, because the resistors R2 and R3 are approximately the same magnitude the voltage drops across them are approximately the same. The voltage drop across each is therefore approximately 1.8 volts, making the voltage at point P approximately 3.2 volts and that at point Q approximately 1.8 volts. Under these conditions both transistors T1, T2 are switched on because the voltages of their bases are sufficiently lower than the voltages at their emitters. Thus current flows in resistors R5 and R7. This causes significant voltages between points X and Y and ground, or logic 1 outputs as shown in Figure 2.

Point A High (12 volts)

This causes the second diodes to be reversed biased and therefore they do not conduct, causing point P to be at the voltage of the first source, 5 volts. However, diode D1 does of course conduct and this raises the voltage at point Q to 5.7 volts. The voltages at the bases of the transistors are therefore at or above the voltages at their emitters and therefore they are both switched off. No current therefore flows in resistors R5 and R7 causing the voltages at points X and Y to be zero or a logic 0, as shown in Figure 2.

Point A Floating

In this condition, the portion of the circuit comprising resistor R3, diode D1, capacitor C and diode D3 can be ignored. Second diodes D2a and D2b conduct and the voltages at P and Q are determined by the "potential divider" effect of resistors R2 and R1. However, because R1 is so much greater than R2, the voltage drop across R2 is very small causing the voltage at P to be close to 5 volts and thus transistor T1 is switched off. The voltage at Q however is approximately 1.4 volts lower than at P owing to the voltage drop of 0.7 volts across each second diode. Thus transistor T2 is switched on. This in turn creates logic outputs of 0 and 1 at points X and Y respectively.

It will therefore be seen that there is a unique combination of the logic outputs at points X and Y for each of the three states of the voltage at point A. The state of the voltage at point A is therefore indicated by the outputs at X and Y.

As will be appreciated, the necessary voltages at points P and Q for the three states at A are created by virtue of the inherent voltage drops across the diodes D1, D2a and D2b when conducting and by choosing the value of the resistors R1, R2 and R3 appropriately. R2 is chosen so that its resistance is not considerably less than the resistance of R3. In the condition of point A being low, sufficient voltage is thus dropped across resistor R2 to switch transistor T1 on. With point A in the floating condition, R1 is so much bigger than R2 that the voltage drop across R2 is sufficiently small to cause transistor T1 to be switched off.

It is possible to use only one second diode because its typical conducting voltage drop, 0.7 volts, is more than that normally required between the base and emitter of each transistor to cause it to conduct. However, by using two second diodes in cascade as in the embodiment, these provide a larger voltage drop which will compensate for temperature variation and tolerances in the circuit components. The diodes shown are ordinary diodes but Zener diodes may alternatively be used oriented in the opposite direction. The voltage of the first voltage source may be lower than the high voltage to be detected at point A, as in the embodiment described, but may also be equal to that high voltage or even slightly greater as long as transistor T2 (and transistor T1) is switched off when point A is at the high voltage.

Claims

1. A device for detecting whether the voltage at a point is low, high or floating comprising a first voltage source, a second voltage source having a voltage less than the voltage of the first source, voltage drop causing means for connection at one end to the point, a first resistor connected between the said one end of the voltage drop causing means and the second voltage source, a second resistor connected between the other end of the voltage drop causing means and the first voltage source, and means responsive to the voltages on either side of the voltage drop causing means to provide an indication of the voltage at the point.

2. A device as claimed in claim 1 wherein the voltage drop causing means comprises at least one diode with its conducting direction away from the first source.

3. A device as claimed in claim 2 wherein the voltage drop causing means comprises two diodes connected in series.

4. A device as claimed in claim 1 wherein the voltage drop causing means comprises at least one Zener diode.

5. A device as claimed in any preceding claim wherein the resistance of the first resistor is much greater than the resistance of the second resistor.

6. A device as claimed in any preceding claim further comprising a third resistor via which the one end of the voltage drop causing means is connected to the point.

7. A device as claimed in claim 6 wherein the resistance of the second resistor is not considerably less than the resistance of the third resistor.

8. A device as claimed in claim 6 or claim 7 wherein the resistances of the second and third resistors are of approximately the same magnitude.

9. A device as claimed in any preceding claim further comprising a diode connected between the one end of the voltage drop causing means and the first voltage source with its conducting direction towards that source.

10. A device as claimed in any preceding claim further comprising a diode connected between the one end of the voltage drop causing means and the second source with its conducting direction away from that source.

11. A device as claimed in any preceding claim wherein the voltage responsive means comprises first and second transistors each connected between the first and second sources and having their bases connected respectively to either side of the voltage drop causing means.

12. A device as claimed in claim 11 wherein the transistors are of pnp type with their emitters connected to the first source and their collectors connected to the second source.

13. A device as claimed in claim 12 wherein the collectors are connected via resistors to the second source, the voltages at the collectors being used to provide the indication of the voltage at the point.

## FIG.1

## FIG.2

| A | | X | Y |
|---|---|---|---|
| | LOW | I | O |
| | HIGH | O | O |
| | FLOATING | O | I |

| | **DOCUMENTS CONSIDERED TO BE RELEVANT** | | EP 86305142.1 |
|---|---|---|---|

| Category | Citation of document with indication, where appropriate, of relevant passages | Relevant to claim | CLASSIFICATION OF THE APPLICATION (Int. Cl.4) |
|---|---|---|---|
| A | GB - A - 2 128 344 (FORD) <br> * Fig.2 * <br> ---- | 1 | G 01 R 19/165 |
| | | | **TECHNICAL FIELDS SEARCHED (Int. Cl.4)** |
| | | | G 01 R 19/00 |

The present search report has been drawn up for all claims

| Place of search | Date of completion of the search | Examiner |
|---|---|---|
| VIENNA | 21-10-1986 | KUNZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82